# EUROPEAN PATENT SPECIFICATION

(11) **EP 4 465 447 B1**
(45) Date of publication and mention of the grant of the patent: **02.09.2026**
(21) Application number: 24175979.4
(22) Date of filing: 15.05.2024
(51) Int. Cl.: H01Q 9/04, H01M 10/42, H01Q 9/40, H01Q 9/42, H01P 3/00, H01Q 1/38

(54) **PRINTED CIRCUIT BOARD, AND BATTERY MANAGEMENT SYSTEM AND BATTERY PACK INCLUDING THE SAME**
LEITERPLATTE UND BATTERIEVERWALTUNGSSYSTEM UND BATTERIEPACK DAMIT
CARTE DE CIRCUIT IMPRIMÉ, ET SYSTÈME DE GESTION DE BATTERIE ET BLOC-BATTERIE L'INCLUANT

(30) Priority: 19.05.2023 KR 20230065163
(43) Date of publication of application: 20.11.2024
(73) Proprietor: Samsung SDI Co., Ltd., Yongin-si, Gyeonggi-do 17084 (KR)
(72) Inventor: Bae, Jin Cheol, 17084 Yongin-si, Gyeonggi-do (KR)
(74) Representative: Gulde & Partner

(56) References cited:
- CN-A- 102 738 569
- KR-A- 20090 133 072
- US-A1- 2017 085 000
- US-A1- 2022 029 204
- TSOI MAN HO ET AL: "Planar Antenna Design for Internet of Things Applications", INTECHOPEN, 23 September 2020 (2020-09-23), XP093207969, Retrieved from the Internet <URL:https://www.intechopen.com/chapters/72152> [retrieved on 20240924]
- WALLACE RICHARD: "Application Note AN058, Antenna Selection Guide", TEXAS INSTRUMENTS, 1 January 2010 (2010-01-01), pages 1 - 45, XP055933845, Retrieved from the Internet <URL:https://www.ti.com/lit/an/swra161b/swra161b.pdf?ts=1655783707925> [retrieved on 20220621]

## Description

### BACKGROUND

### 1. Field

The present disclosure relates to a printed circuit board, and to a battery management system including the printed circuit board and a battery pack including the battery management system.

### 2. Description of the Related Art

A secondary battery, which may be repeatedly charged and discharged, differs from a primary battery, which instead provides only irreversible conversion of chemical energy to electrical energy. A low-capacity secondary battery is used as a power supply for a small electronic device, such as a mobile phone, a laptop computer, or a camcorder, and a high-capacity secondary battery is used as a power supply for a hybrid vehicle or the like.

In general, a secondary battery cell includes an electrode assembly including a positive electrode, a negative electrode, and a separator interposed between the positive electrode and the negative electrode, a case accommodating the electrode assembly, and an electrode terminal electrically connected to the electrode assembly. An electrolyte solution is injected into the case to enable charging and discharging of the battery cell through an electrochemical reaction between the positive electrode, the negative electrode, and the electrolyte solution. A shape of the case, such as a cylindrical or rectangular shape varies depending on a use of the battery cell.

Battery cells may be connected in series and/or in parallel to form a battery module with high energy density. A battery pack may include one or more of battery modules according to a suitable specification.

The battery pack includes a battery management system (BMS) for monitoring, controlling, and/or setting the battery pack. The BMS may include a battery system manager (BSM) operating as a master control device, a battery management module (BMM) operating as a slave control device, and a battery disconnect unit (BDU) that blocks or allows a connection between the battery pack and an external device depending on a function. The BMM measures and balances states (e.g., a voltage, a temperature, a current, and the like) of the cells included in the battery module, and transmits state information, event occurrence information, and the like detected in the process to the BSM that is the master.

There has recently been an increasing number of cases where the control devices inside the battery pack are designed to communicate using wireless communication. For example, the BMM is designed to measure a cell voltage, a module voltage, a temperature, or the like and then transmit the measurement result to the BSM through wireless communication.

On the other hand, for the BMM to communicate with the BSM wirelessly, an antenna that transmits and receives a wireless signal may be required to secure robustness of wireless communication by increasing transmission output and reception sensitivity of the wireless signal, the antenna that transmits and receives the wireless signal has to be designed to match a desired frequency band.

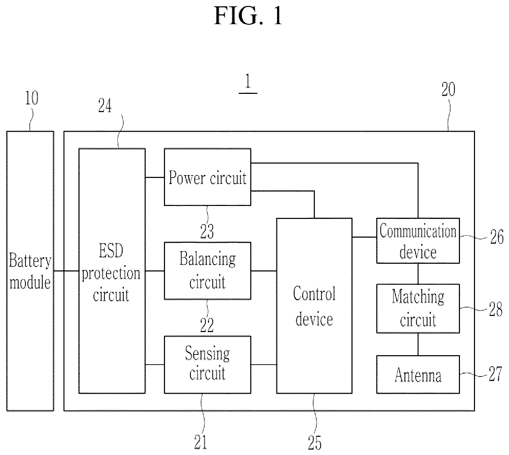

The BMS is often manufactured by mounting components included in the BMS circuit on a flexible printed circuit board (PCB). Typically, a rigid PCB may have a thickness of 1 mm to 1.6 mm, and may include a plurality of dielectric layers and a plurality of copper layers between top and bottom surfaces thereof. The dielectric layer may be designed to have a sufficient thickness to enable an antenna pattern and a circuit design in each layer. On the other hand, the flexible PCB has a structure in which it may be difficult to secure a sufficient thickness of the dielectric layer. Therefore, an antenna mounted on the flexible PCB is mainly mounted on the PCB in the form of a chip or a surface mount device (SMD). The US 2017/085000 A1 discloses an antenna structure integrated in a printed circuit board having a first portion of the antenna structure and a first ground plane on a first layer and another portion of the antenna and a second ground plane on a second layer that are respectively connected by conductive vias. The CN 102 738 569 A discloses a broadband PCB antenna having two grounding planes connected to each other, wherein a first ground plane has a U-shaped structure where a vibrator is placed in the first ground plane. The article Tsoi Man Ho ET AL: "Planar Antenna Design 2,3 for Internet of Things Applications", Intechopen, 23 September 2020 (2020-09-23), XP093207969, Retrieved from the Internet: URL:https://www.intechopen.com/chapters/72 152, [retrieved on 2024-09-24], pages 1-16; figures 1-11 discloses a planar antenna on a PCB including an impedance matching network. The article WALLACE RICHARD: "Application Note AN058, Antenna Selection Guide", TEXAS INSTRUMENTS, 1 January 2010 (2010-01-01), pages 1-45, XP055933845, Retrieved from the Internet: URL:https://www.ti.com/lit/an/swra161b/swra161b.pdf?ts=1655783707925 [retrieved on 2022-06-21], figures 1-41 discloses inverted F-shape antennas. The KR 2009 0133072 A discloses an antenna device on a PCB. The US 2022/029204 A1 discloses a battery pack with battery module and battery management system using wireless communication via different antennas. However, if an antenna component having the form of the chip or the surface mount device (SMD) is used, there may be a problem in which frequency-band matching using the antenna component is difficult or impossible.

### SUMMARY

The present disclosure provides a printed circuit board that may solve a problem in which it is difficult to match a frequency band of an antenna that implements a battery management system with a wireless communication function using a printed circuit board (PCB), and provides the battery management system and a battery pack including the printed circuit board.

A printed circuit board according the invention is disclosed in claim 1 of the appended set of claims.

The printed circuit board may further include: a matching circuit region disposed on the first surface, and in which an impedance-matching circuit adjusting a frequency band to which the pattern antenna is matched through impedance matching is mounted, and a second trace that is formed to pass through the matching circuit region on the first surface and transfers a signal between the first trace and the pattern antenna. The first trace may function as a signal transfer between the radio frequency integrated circuit and the impedance-matching circuit.

The fill-cut pattern may extend to cover the second trace.

The pattern antenna may include: an antenna body; and a signal transfer pattern protruding from the antenna body, and having a wire shape connected to the second trace.

A width of the fill-cut pattern may be wider than a width of the first trace.

At least a portion of the pattern antenna may be connected to the first ground pattern.

The printed circuit board may further include a second ground pattern disposed on the first surface and spaced apart from the first trace by a predetermined interval to be formed to surround the first trace.

A conductive pattern may not be disposed at a region corresponding to the pattern antenna on the second surface.

The printed circuit board may further include at least one via hole formed around the fill-cut pattern for impedance matching.

The printed circuit board may include a flexible printed circuit board.

A battery management system may include a printed circuit board according to the above embodiments.

A battery management system according to embodiments includes: the printed circuit board according to one of the above amendments; the radio frequency integrated circuit mounted on the first surface; and an impedance-matching circuit mounted in the matching circuit region. The radio frequency integrated circuit and the impedance-matching circuit are connected to the pattern antenna by the first trace and a second trace.

A battery pack according to embodiments includes: a battery module; and the battery management system according above embodiments.

A printed circuit board according to embodiments includes a first surface, a second surface that is substantially parallel to the first surface, a pattern antenna on the first surface, a first ground pattern formed on the second surface; a radio frequency integrated circuit mounted on the first surface; a first trace for transferring a signal between the radio frequency integrated circuit on the first surface and the pattern antenna, and a fill-cut pattern on the second surface and covering an entirety of the first trace, wherein the fill-cut pattern is formed by removing a portion of the first ground pattern in a line shape corresponding to the first trace.

The printed circuit board may further include a matching circuit region on the first surface, and in which an impedance-matching circuit for adjusting a frequency band to which the pattern antenna is matched through impedance matching is mounted, and a second trace passing through the matching circuit region on the first surface for transferring a signal between the first trace and the pattern antenna, wherein the first trace functions as a signal transfer between the radio frequency integrated circuit and the impedance-matching circuit.

The fill-cut pattern may cover the second trace.

The pattern antenna may include an antenna body, and a signal transfer pattern protruding from the antenna body, and having a wire shape connected to the second trace.

A width of the fill-cut pattern may be wider than a width of the first trace.

At least a portion of the pattern antenna may be connected to the first ground pattern.

The printed circuit board may further include a second ground pattern on the first surface, and spaced apart from the first trace to surround the first trace in plan view. A conductive pattern may be not at a region corresponding to the pattern antenna on the second surface.

The printed circuit board may further include at least one via hole adjacent the fill-cut pattern for impedance matching.

The printed circuit board may include a flexible printed circuit board.

A battery management system according to embodiments includes the printed circuit board, the radio frequency integrated circuit, and an impedance-matching circuit for adjusting a frequency band to which the pattern antenna is matched through impedance matching, wherein the radio frequency integrated circuit and the impedance-matching circuit are connected to the pattern antenna by the first trace and a second trace.

A battery pack according to embodiments includes a battery module and the battery management system above.

According to the present disclosure, if a battery management system with wireless communication function using a flexible printed circuit board (PCB) is implemented, a problem in which it is difficult to match frequency band of an antenna may be resolved.

### BRIEF DESCRIPTION OF THE DRAWINGS

FIG. 1 is a structural diagram schematically showing a battery pack according to embodiments.
FIGS. 2A to 2G each show a pattern antenna according to embodiments.
FIG. 3 shows a matching circuit of a battery management system according to embodiments.
FIG. 4 shows a flexible printed circuit board (PCB) of a battery management system according to embodiments.
FIG. 5A is an enlarged view of a portion of an upper surface radio frequency (RF) block of the flexible printed circuit board of FIG. 4.
FIG. 5B is an enlarged view of a portion of a lower surface RF block of the flexible printed circuit board of FIG. 4.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from and scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Hereinafter, a printed circuit board according to embodiments, and a battery management system and a battery pack including the same will be described in detail with reference to necessary drawings.

FIG. 1 is a structural diagram schematically showing the battery pack according to embodiments.

Referring to FIG. 1, the battery pack 1 may include a battery module 10 and a battery management system (BMS) 20.

The battery module 10 may include a plurality of battery cells connected in series and/or in parallel.

The BMS 20 may include a sensing circuit (or a detection circuit) 21, a balancing circuit 22, a power circuit (or a power supply circuit) 23, a control device 25, a communication device 26, an antenna (e.g., pattern antenna) 27, and a matching circuit (e.g., impedance-matching circuit) 28.

The sensing circuit 21 may detect a cell voltage, a module voltage, a temperature, or the like from the battery module 10, and may transfer the detection result to the control device 25.

The balancing circuit 22 may perform a balancing function between the battery cells of the battery module 10 under a control of the control device 25.

The power circuit 23 may receive the module voltage supplied from the battery module 10, and may use the received module voltage to supply driving power for driving the control device 25 and the communication device 26 that will be described later.

The BMS 20 may further include an electrostatic discharge (ESD) protection circuit 24 located between the battery module 10 and at least one of the sensing circuit 21, the balancing circuit 22, or the power circuit 23. The ESD protection circuit 24 may perform a function of protecting the BMS from an ESD and/or a surge flowing into the BMS 20 from the outside.

The control device 25 may obtain state information (e.g., the cell voltage, the module voltage, the temperature, or the like) of the battery module 10 through the sensing circuit 21, and may perform state diagnosis of the battery module 10 based on the state information. The control device 25 may transmit the state information, diagnosis information, or the like, which is detected from the battery module 10, to an upper controller through wireless communication. The control device 25 may control a balancing of the battery module 10 by controlling the balancing circuit 22 based on the state information of the battery module 10. For example, the control device 25 may include an analog front end (AFE) integrated circuit (IC).

The communication device 26 and the antenna 27 may be used for wireless communication between the control device 25 and the upper controller.

The communication device 26 may transmit and receive a wireless signal of a frequency band (e.g., a predetermined frequency band) through the antenna 27 to communicate with the upper controller. The communication device 26 may transmit information received from the control device 25 to the upper controller through the antenna 27. The communication device 26 may transfer a signal received from the upper controller through the antenna 27 to the control device 25. For example, the communication device 26 may include a radio frequency (RF) IC.

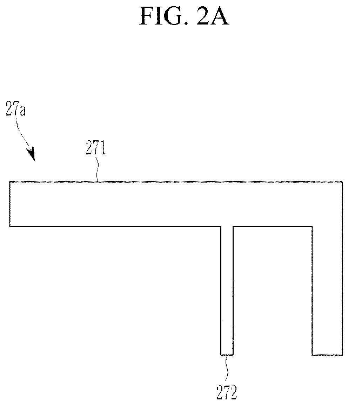

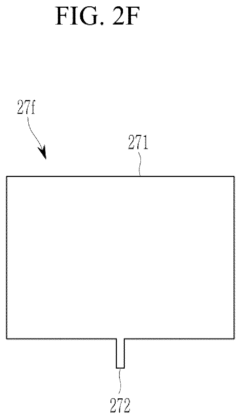

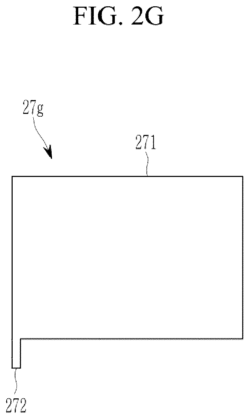

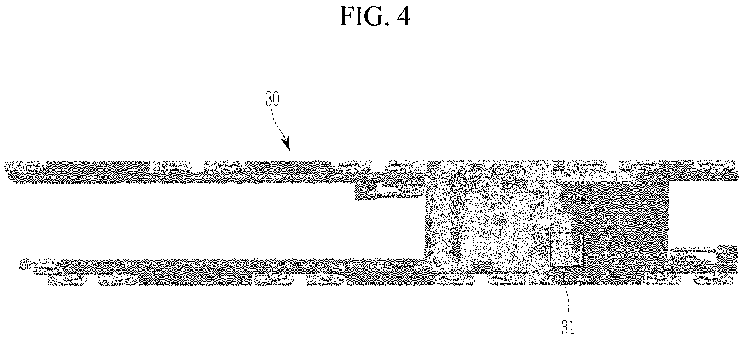

The antenna 27 may radiate a signal received from the communication device 26 as a wireless signal, and/or may receive a wireless signal transmitted from the upper controller to transfer the received signal to the communication device 26. The antenna 27 is configured in the form of a pattern antenna. The pattern antenna may be patterned using a conductive material on one surface of a printed circuit board (PCB) 30 of FIG. 4 on which the BMS 20 is mounted. FIGS. 2A to 2G show examples of the antenna 27 implemented as the pattern antenna.

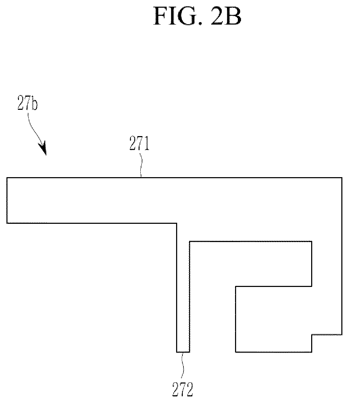

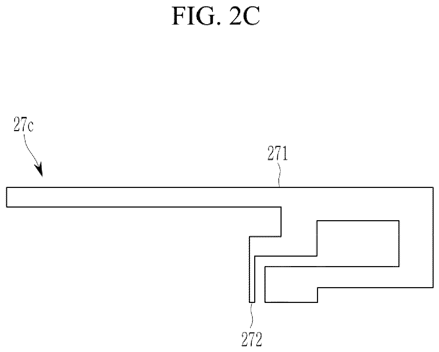

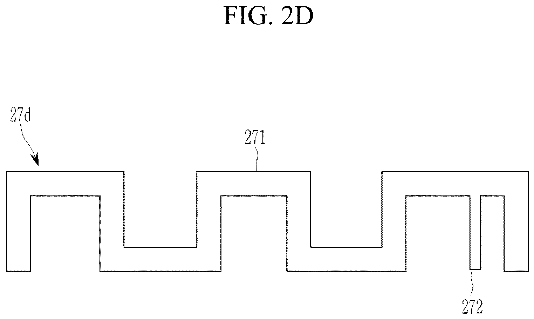

Referring to FIGS. 2A to 2D, the antenna 27a, 27b, 27c, or 27d may include an antenna body 271 that is bent one or more times, and a wire-shaped signal transfer pattern 272 protruding from the antenna body 271. For example, the antenna 27a of FIG. 2A may include an F-shaped antenna pattern. For example, the F-shaped antenna pattern may include an extended portion extending from an upper end of the antenna body 271 and the signal transfer pattern 272 extends parallel to the extended portion. The extended portion at the upper end may be used to connect to a ground pattern 314 as explained further below. The pattern antennas 27b and 27c of FIGS. 2B and 2C may include a shape that is slightly modified from the F-shaped antenna 27a of FIG. 2A. For example, the antenna pattern of the antennas 27b and 27c may include a reversely extending portion which extends from an end of the extended portion at the upper end toward the signal transfer pattern 272 while remaining spaced from the signal transfer pattern 272 to avoid interference. In some embodiments, the antenna 27d of FIG. 2D may have a shape in which one end portion of the F-shaped antenna 27a of FIG. 2A is extended, e.g. from a base portion of the (F-shaped) antenna body 271, and the extended portion may include a serpentine shape by repeatedly bending the extended portion.

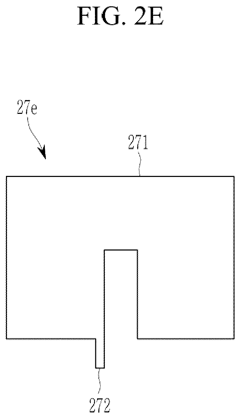

Referring to FIGS. 2E to 2G, the antenna 27e, 27f, or 27g may include a planar-shaped antenna body 271 and a wire-shaped signal transfer pattern 272 protruding from the planar-shaped antenna body 271.

Like the embodiments shown in FIGS. 2A to 2G, a pattern shape, a pattern area, a pattern width, or the like of the antenna 27 may be variously modified. For example, in FIGS. 2A to 2D, the antenna body 271 of the antenna 27 may be bent 1 time (see FIG. 2A), may be bent 2 times (see FIGS. 2B and 2C), and may be bent 10 times (see FIG. 2D), but various modifications are possible in a direction in which the antenna body 271 is bent, the number of times the antenna body 271 is bent, and the like. For example, the signal transfer pattern 272 may be a straight-wire shape shown in FIGS. 2A, 2B, and 2D to 2G, or may be a bent wire shape shown in FIG. 2C.

The antenna 27 may be patterned on the PCB with a metal or an alloy material depending on a suitable electrical conductivity, a suitable electrical property, or a suitable mechanical property, such as ductility or the like. For example, the antenna 27 may be formed by patterning an antenna pattern of a corresponding shape on one surface of the PCB using a metal material, such as copper, tin, silver, gold, or the like.

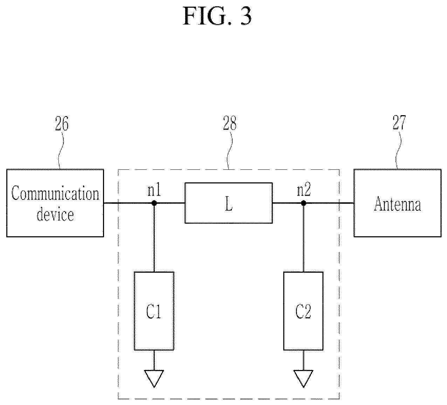

Referring back to FIG. 1, the matching circuit 28 may be connected between the communication device 26 and the antenna 27. FIG. 3 shows an example of the matching circuit 28. For example, the matching circuit 28 may include an inductor L connected on a signal transfer path between the communication device 26 and the antenna 27, may include a capacitor C1 connected between a ground and a node n1 that is between the communication device 26 and the inductor L, and may include a capacitor C2 connected between a ground and a node n2 that is between the inductor L and the antenna 27.

The matching circuit 28 may function to adjust the antenna 27 to match a desired communication frequency band by matching impedances seen from an input side and an output side of the matching circuit 28. For example, the matching circuit 28 may function to compensate for a characteristic of the antenna 27 being deteriorated due to a characteristic of the flexible printed circuit board (PCB) if the antenna 27 is coupled to the flexible PCB. For example, the antenna 27 on one surface of the flexible PCB may be formed so that a frequency of the antenna 27 matches a frequency band near the desired communication frequency band (e.g., a 2.4 GHz band), and the matching circuit 28 may precisely adjust an impedance so that the frequency of the antenna 27 closely matches a center frequency of the desired communication frequency band (e.g., about 2.44 GHz).

The BMS 20 may further include the flexible PCB 30 of FIG. 4 on which the pattern antenna 27 is mounted. Further components that are mounted on the flexible PCB 30 may be the sensing circuit 21, the balancing circuit 22, the power circuit 23, the ESD protection circuit 24, the control device 25, the communication device 26, the antenna 27, and/or the matching circuit 28. The sensing circuit 21, the balancing circuit 22, the power circuit 23, the ESD protection circuit 24, the control device 25, the communication device 26, the antenna 27, and/or the matching circuit 28 of the BMS 20 may be mounted on the flexible PCB 30, and may be mounted within the battery pack 1.

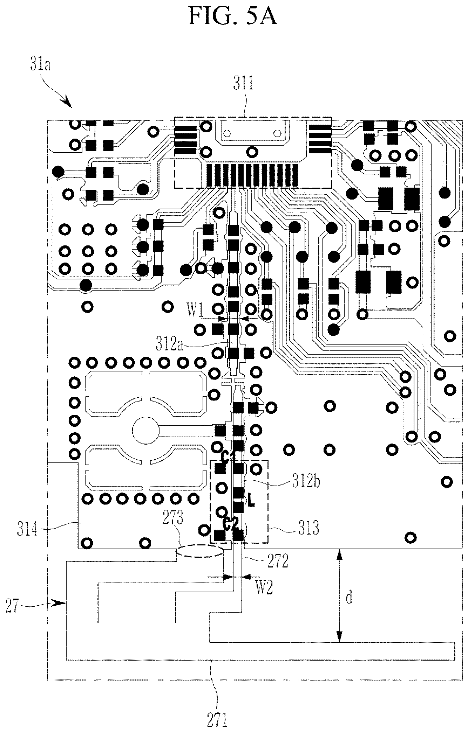

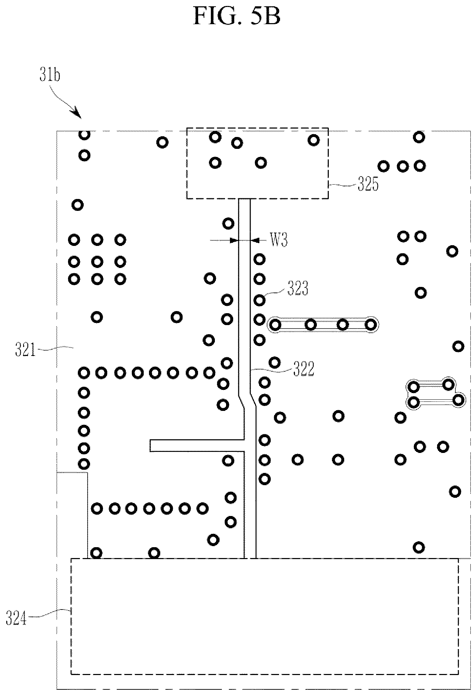

FIG. 4 shows an example of the flexible PCB of the BMS 20 according to embodiments. FIGS. 5A and 5B are enlarged views of a portion 31 of the flexible PCB of FIG. 4 that is a portion of a region where a radio frequency (RF) block for wireless communication is located, and show an upper surface 31a and a lower surface 31b, respectively.

Referring to FIGS. 4, 5A, and 5B, a plurality of components that include a radio frequency integrated circuit (RFIC) included in the communication device 26, the inductor L and the capacitors C1 and C2 included in the matching circuit 28, and the like, may be mounted on the upper surface 31a (e.g., a first surface) of the flexible PCB 30, and the antenna 27 may be formed on the upper surface 31a of the flexible PCB 30.

Referring to FIG. 5A, a first trace 312a and/or a second trace 312b for transferring a signal between the radio frequency integrated circuit and the antenna 27 may be formed between the antenna 27 and a region 311 where the radio frequency integrated circuit is coupled on the upper surface 31a of the flexible PCB 30. The trace 312a may be a signal transfer wire connected between the communication device 26 including the radio frequency integrated circuit and the matching circuit 28, and may be a straight-line shape that is not bent. The trace 312b may be a signal transfer wire connected between the trace 312a and the antenna 27, and may pass through a region 313 where the matching circuit 28 is mounted. A width W1 of the trace 312a or 312b may be determined for the impedance matching.

A ground pattern (e.g., second ground pattern) 314 may be formed around the traces 312a and 312b to surround the traces 312a and 312b (e.g., in plan view), and the ground pattern 314 may be spaced apart from the traces 312a and 312b by an interval (e.g., a predetermined interval, for example, 0.15 mm).

The antenna 27 is mounted on the upper surface 31a of the flexible PCB 30. The signal transfer pattern 272 of the antenna 27 may be connected to the trace 312b. In one or more embodiments, a signal between the antenna 27 and the radio frequency integrated circuit may be transferred through the signal transfer pattern 272 of the antenna 27 and the traces 312a and 312b. The signal transfer pattern 272 of the antenna 27 may have the same width W2 as that of the trace 312a or 312b.

The antenna 27 may be formed so that at least a portion of the pattern antenna is connected to a ground. Referring to FIG. 5A, a portion 273 of the antenna 27 may be connected to the ground pattern 314. The antenna 27 may ensure a sufficient distance (e.g., 5.8 mm or more) d between the ground pattern 314 and one end portion of the pattern antenna 27 not connected to the ground pattern 314 to avoid interference. In the present specification, the ground pattern 314 may refer to a conductor layer connected to a ground.

Referring to FIG. 5B, to improve matching performance for the communication frequency band, the flexible PCB 30 includes a fill-cut pattern 322. The fill-cut pattern 322 is formed on the lower surface 31b of the flexible PCB 30. The fill-cut pattern 322 is a pattern in which a portion of a ground pattern (e.g., first ground pattern) 321 on the lower surface 31b of the flexible PCB 30 is removed in a line shape. That is, the fill-cut pattern 322 may be a pattern in which a portion of a bare board of the flexible PCB 30 is exposed to the outside in a line shape. The fill-cut pattern 322 may be on the lower surface 31b of the flexible PCB 30 between a region 325 that corresponds to the radio frequency integrated circuit and a region 324 that corresponds to the antenna 27. The fill-cut pattern 322 is formed on the lower surface 31b to cover, e.g. overlap, a region where the traces 312a and/or 312b are formed. In other words, the fill-cut pattern 322 is formed in a region corresponding to a region where the traces 312a and 312b of the upper surface 31a are to thereby cover a region where the traces 312a and 312b are, e.g., in a plan view. Due to the fill-cut pattern 322 corresponding to the first trace 312a and/or the second trace 312a no conductive part corresponds to where the first trace 312a and/or the second trace 312b are located so that matching performance for the desired communication frequency band can be improved. A width W3 of the fill-cut pattern 322 may be wider than the width W1 of the trace 312a or 312b so that the entire traces 312a and 312b may be covered by the fill-cut pattern 322. The width relation further improves matching performance. For example, if the width W1 of the trace 312a or 312b is 0.5 mm, the width W3 of the fill-cut pattern 322 may be 0.75 mm.

To further improve matching performance for the communication frequency band, the flexible PCB 30 may further include a plurality of via holes 323 adjacent to the fill-cut pattern 322. For example, the region 324 corresponding to the antenna 27 may be formed so as not to dispose any conductive pattern (e.g., a ground pattern) on the lower surface 31b of the flexible PCB 30.

Even though the BMS 20 is configured using the flexible PCB 30 in the battery pack 1, precise frequency matching is possible using the antenna 27 and the matching circuit 28 on one surface of the flexible PCB 30, the fill-cut pattern 322 on the other surface of the flexible PCB 30. A further improvement of the frequency matching can be reached through the plurality of via holes 323 formed around the fill-cut pattern 322. Therefore, by improving matching performance for the desired communication frequency band, wireless communication performance (e.g., transmission output and reception sensitivity) of the BMS 20 may be improved, and robustness of the wireless communication may be secured.

Electronic or electrical devices according to embodiments of the present disclosure and/or other related devices or constituent elements may be realized by using appropriate hardware, firmware (e.g., an application-specific integrated circuit), software, or combinations of software, firmware, and hardware. For example, various configurations of the above-noted devices may be positioned on one integrated circuit (IC) chip or an individual IC chip. In one or more embodiments, various configurations of the above-noted devices may be realized on a flexible printed circuit film, a tape carrier package (TCP), a printed circuit board (PCB), or one substrate. The electrical or mutual connections described in the present specification may, for example, be realized by the PCB, wires on different types of circuit carriers, or conductive elements. The conductive elements may, for example, include metallization, such as surface metallizations and/or pins, and may include conductive polymers or ceramics.

In one or more embodiments, the various configurations of the devices may be performed by at least one processor so as to perform the above-described various functions, they may be performed in at least one computing device, and they may be processes or threads for performing computer program instructions and interacting with other system constituent elements. The computer program instruction is stored in a memory realizable in a computing device using a standard memory device, such as a random access memory (RAM). The computer program instruction may also be stored in a non-transitory computer readable medium, such as a CD-ROM or a flash drive.

Further, a person of ordinary skill in the art must understand that various functions of the computing device may be combined or united to a single computing device, or functions of a specific computing device may be dispersed to at least another computing device while not digressing from the range of the embodiments of the present disclosure.

### Description of Some of the Reference Characters

| | | | | | |
|---|---|---|---|---|---|
| 1: | battery pack | 10: | battery module | 20: | battery management system |
| 21: | sensing circuit | 22: | balancing circuit | 23: | power circuit |
| 24: | ESD protection circuit | 25: | control unit | 26: | communication device |
| 27, 27a - 27g: | antenna | 28: | matching circuit | 30: | flexible PCB |
| 312a, 312b: | trace | 322: | fill-cut pattern | 323: | via hole |
| 314, 321: | ground pattern | | | | |

## Claims

1. A printed circuit board (30) for a battery management system (20), the printed circuit board (30) comprising:
a first surface (31a);
a second surface (31b) that is parallel to the first surface (31a);
a pattern antenna (27; 27a, ..., 27g) formed on the first surface (31a);
a first ground pattern (321) formed on the second surface (31b);
a radio frequency integrated circuit mounted on the first surface (31a);
a first trace (312a) on the first surface (31a) for transferring a signal between the radio frequency integrated circuit mounted on the first surface (31a) and the pattern antenna (27; 27a, ..., 27g); and a fill-cut pattern (322) formed on the second surface (31b) and formed to cover an entirety of the first trace (312a) in plan view, wherein the fill-cut pattern (322) is formed by removing a portion of the first ground pattern (321) formed on the second surface (31b) in a line shape corresponding to the first trace (312a).

2. The printed circuit board (30) according to claim 1, further comprising:
a matching circuit region (313) disposed on the first surface (31a), and in which an impedance-matching circuit (28) for adjusting a frequency band to which the pattern antenna (27; 27a, ..., 27g) is matched through impedance matching is mounted; and
a second trace (312b) passing through the matching circuit region (313) on the first surface (31a) for transferring a signal between the first trace (312a) and the pattern antenna (27; 27a, ..., 27g),
wherein the first trace (312a) functions as a signal transfer between the radio frequency integrated circuit and the impedance-matching circuit (28).

3. The printed circuit board (30) according to claim 2, wherein the fill-cut pattern (322) extends to cover the second trace (312b) in plan view.

4. The printed circuit board (30) according to one of the claims 2 to 3, wherein the pattern antenna (27; 27a, ..., 27g) comprises:
an antenna body (271); and
a signal transfer pattern (272) protruding from the antenna body (271), and having a wire shape connected to the second trace (312b).

5. The printed circuit board (30) according to claim **4,** wherein the pattern antenna (27) comprises an F-shaped pattern antenna (27a), wherein the F-shaped pattern antenna (27a) comprises an extended portion extending from an upper end of the antenna body (271) and the signal transfer pattern (272) extends parallel to the extended portion.

6. The printed circuit board (30) according to claim 5, wherein the F-shaped pattern antenna (27b, 27c) comprises a reversely extending portion extending from an end of the extended portion toward the signal transfer pattern (272) while remaining spaced from the signal transfer pattern (272).

7. The printed circuit board (30) according to claim **4,** wherein the pattern antenna (27e, 27f, 27g) comprises a planar-shaped antenna body (271) and the wire-shaped signal transfer pattern (272) protrudes from the planar-shaped antenna body (271).

8. The printed circuit board (30) according to one of the claims 1 to 7, wherein a width (W3) of the fill-cut pattern (322) is wider than a width of the first trace (312a).

9. The printed circuit board (30) according to one of the claims 1 to 8, wherein at least a portion (273) of the pattern antenna (27; 27a, ..., 27g) is connected to a second ground pattern (314) on the first surface (31a).

10. The printed circuit board (30) according to claim 9, wherein the second ground pattern (314) on the first surface (31a) is spaced apart from the first trace (312a) to surround the first trace (312a) in plan view.

11. The printed circuit board (30) according to one of the claims 1 to 10, wherein a conductive pattern is not at a region (324) corresponding to the pattern antenna (27) on the second surface (31b).

12. The printed circuit board (30) according to one of the claims 1 to 11, further comprising at least one via hole (323) formed around the fill-cut pattern (322) for impedance matching.

13. The printed circuit board (30) according to one of the claims 1 to 12, wherein the printed circuit board (30) comprises a flexible printed circuit board.

14. A battery management system (20), comprising the printed circuit board (30) according to one of the claims 1 to 13.

15. A battery pack (1), comprising:
a battery module (10); and
the battery management system (20) according to claim 14.

## Patentansprüche

1. Leiterplatte (30) für ein Batterieverwaltungssystem (20), wobei die Leiterplatte (30) Folgendes umfasst:
eine erste Oberfläche (31a);
eine zweite Oberfläche (31b), die parallel zur ersten Oberfläche (31a) verläuft;
eine auf der ersten Oberfläche (31a) ausgebildete Musterantenne (27; 27a, ..., 27g);
ein auf der zweiten Oberfläche (31b) ausgebildetes erstes Erdungsmuster (321);
eine auf der ersten Oberfläche (31a) montierte integrierte Funkfrequenzschaltung;
eine erste Leiterbahn (312a) auf der ersten Oberfläche (31a) zur Übertragung eines Signals zwischen der auf der ersten Oberfläche (31a) montierten integrierten Funkfrequenzschaltung und der Musterantenne (27; 27a, ..., 27g); und ein Füllschnittmuster (322), das auf der zweiten Oberfläche (31b) ausgebildet und so gestaltet ist, dass es in der Draufsicht die gesamte erste Leiterbahn (312a) bedeckt, wobei das Füllschnittmuster (322) durch Entfernen eines Abschnitts des auf der zweiten Oberfläche (31b) ausgebildeten ersten Erdungsmusters (321) in einer Linienform entsprechend der ersten Leiterbahn (312a) gebildet wird.

2. Leiterplatte (30) nach Anspruch 1, umfassend ferner:
einen Anpassungsschaltungsbereich (313), der auf der ersten Oberfläche (31a) angeordnet ist und in dem eine Impedanzanpassungsschaltung (28) zum Einstellen eines Frequenzbandes, an das die Musterantenne (27; 27a, ..., 27g) durch Impedanzanpassung angepasst wird, montiert ist; und
eine zweite Leiterbahn (312b), die durch den Anpassungsschaltungsbereich (313) auf der ersten Oberfläche (31a) verläuft, um ein Signal zwischen der ersten Leiterbahn (312a) und der Musterantenne (27; 27a, ..., 27g) zu übertragen,
wobei die erste Leiterbahn (312a) als Signalübertragung zwischen der integrierten Funkfrequenzschaltung und der Impedanzanpassungsschaltung (28) fungiert.

3. Leiterplatte (30) nach Anspruch 2, wobei sich das Füllschnittmuster (322) in der Draufsicht so erstreckt, dass es die zweite Leiterbahn (312b) bedeckt.

4. Leiterplatte (30) nach einem der Ansprüche 2 bis 3, wobei die Musterantenne (27; 27a, 27g) Folgendes umfasst:
einen Antennenkörper (271); und
ein Signalübertragungsmuster (272), das von dem Antennenkörper (271) vorsteht und eine mit der zweiten Leiterbahn (312b) verbundene Drahtform aufweist.

5. Leiterplatte (30) nach Anspruch 4, wobei die Musterantenne (27) eine F-förmige Musterantenne (27a) umfasst, wobei die F-förmige Musterantenne (27a) einen verlängerten Abschnitt umfasst, der sich von einem oberen Ende des Antennenkörpers (271) erstreckt, und sich das Signalübertragungsmuster (272) parallel zu dem verlängerten Abschnitt erstreckt.

6. Leiterplatte (30) nach Anspruch 5, wobei die F-förmige Musterantenne (27b, 27c) einen sich in umgekehrter Richtung erstreckenden Abschnitt umfasst, der sich von einem Ende des verlängerten Abschnitts in Richtung des Signalübertragungsmusters (272) erstreckt, während er von dem Signalübertragungsmuster (272) beabstandet bleibt.

7. Leiterplatte (30) nach Anspruch 4, wobei die Musterantenne (27e, 27f, 27g) einen planar geformten Antennenkörper (271) umfasst und das drahtförmige Signalübertragungsmuster (272) von dem planar geformten Antennenkörper (271) vorsteht.

8. Leiterplatte (30) nach einem der Ansprüche 1 bis 7, wobei eine Breite (W3) des Füllschnittmusters (322) größer ist als eine Breite der ersten Leiterbahn (312a).

9. Leiterplatte (30) nach einem der Ansprüche 1 bis 8, wobei zumindest ein Abschnitt (273) der Musterantenne (27; 27a, ..., 27g) mit einem zweiten Erdungsmuster (314) auf der ersten Oberfläche (31a) verbunden ist.

10. Leiterplatte (30) nach Anspruch 9, wobei das zweite Erdungsmuster (314) auf der ersten Oberfläche (31a) von der ersten Leiterbahn (312a) beabstandet ist, um die erste Leiterbahn (312a) in der Draufsicht zu umgeben.

11. Leiterplatte (30) nach einem der Ansprüche 1 bis 10, wobei in einem der Musterantenne (27) auf der zweiten Oberfläche (31b) entsprechenden Bereich (324) kein leitfähiges Muster vorhanden ist.

12. Leiterplatte (30) nach einem der Ansprüche 1 bis 11, umfassend ferner mindestens ein Durchkontaktierungsloch (323), das zur Impedanzanpassung um das Füllschnittmuster (322) herum ausgebildet ist.

13. Leiterplatte (30) nach einem der Ansprüche 1 bis 12, wobei die Leiterplatte (30) eine flexible Leiterplatte umfasst.

14. Batterieverwaltungssystem (20), umfassend die Leiterplatte (30) nach einem der Ansprüche 1 bis 13.

15. Batteriepack (1), umfassend:
ein Batteriemodul (10); und
das Batterieverwaltungssystem (20) nach Anspruch 14.

## Revendications

1. Carte de circuit imprimé (30) pour un système de gestion de batterie (20), la carte de circuit imprimé (30) comportant :
une première surface (31a) ;
une deuxième surface (31b) qui est parallèle à la première surface (31a) ;
une antenne à diagramme (27 ; 27a..., 27g) formée sur la première surface (31a) ;
un premier diagramme de masse (321) formé sur la deuxième surface (31b) ;
un circuit intégré radiofréquence monté sur la première surface (31a) ;
une première trace (312a) sur la première surface (31a) pour transférer un signal entre le circuit intégré radiofréquence monté sur la première surface (31a) et l'antenne à diagramme (27 ; 27a..., 27g) ; et un diagramme de remplissage-découpe (322) formé sur la deuxième surface (31b) et formé pour recouvrir une totalité de la première trace (312a) en vue en plan, dans laquelle le diagramme de remplissage-découpe (322) est formé par retrait d'une partie du premier diagramme de masse (321) formé sur la deuxième surface (31b) en une forme de ligne correspondant à la première trace (312a).

2. Carte de circuit imprimé (30) selon la revendication 1, comportant en outre :
une région de circuit d'adaptation (313) disposée sur la première surface (31a), et dans laquelle est monté un circuit d'adaptation d'impédance (28) pour ajuster une bande de fréquences à laquelle l'antenne à diagramme (27 ; 27a..., 27g) est adaptée par adaptation d'impédance ; et
une deuxième trace (312b) traversant la région de circuit d'adaptation (313) sur la première surface (31a) pour transférer un signal entre la première trace (312a) et l'antenne à diagramme (27 ; 27a..., 27g),
dans laquelle la première trace (312a) fonctionne comme un transfert de signal entre le circuit intégré radiofréquence et le circuit d'adaptation d'impédance (28).

3. Carte de circuit imprimé (30) selon la revendication 2, dans laquelle le diagramme de remplissage-découpe (322) s'étend pour recouvrir la deuxième trace (312b) en vue en plan.

4. Carte de circuit imprimé (30) selon l'une des revendications 2 à 3, dans laquelle l'antenne à diagramme (27 ; 27a, .... 27g) comporte :
un corps d'antenne (271) ; et
un diagramme de transfert de signal (272) faisant saillie à partir du corps d'antenne (271) et présentant une forme de fil connectée à la deuxième trace (312b).

5. Carte de circuit imprimé (30) selon la revendication 4, dans laquelle l'antenne à diagramme (27) comporte une antenne à diagramme en forme de F (27a), dans laquelle l'antenne à diagramme en forme de F (27a) comporte une partie étendue s'étendant à partir d'une extrémité supérieure du corps d'antenne (271) et le diagramme de transfert de signal (272) s'étend parallèlement à la partie étendue.

6. Carte de circuit imprimé (30) selon la revendication 5, dans laquelle l'antenne à diagramme en forme de F (27b, 27c) comporte une partie s'étendant en sens inverse qui s'étend à partir d'une extrémité de la partie étendue vers le diagramme de transfert de signal (272) tout en restant espacée du diagramme de transfert de signal (272).

7. Carte de circuit imprimé (30) selon la revendication 4, dans laquelle l'antenne à diagramme (27e, 27f, 27g) comporte un corps d'antenne de forme plane (271) et le diagramme de transfert de signal en forme de fil (272) fait saillie à partir du corps d'antenne de forme plane (271).

8. Carte de circuit imprimé (30) selon l'une des revendications 1 à 7, dans laquelle une largeur (W3) du diagramme de remplissage-découpe (322) est plus large qu'une largeur de la première trace (312a).

9. Carte de circuit imprimé (30) selon l'une des revendications 1 à 8, dans laquelle au moins une partie (273) de l'antenne à diagramme (27 ; 27a..., 27g) est connectée à un deuxième diagramme de masse (314) sur la première surface (31a).

10. Carte de circuit imprimé (30) selon la revendication 9, dans laquelle le deuxième diagramme de masse (314) sur la première surface (31a) est espacé de la première trace (312a) pour entourer la première trace (312a) en vue en plan.

11. Carte de circuit imprimé (30) selon l'une des revendications 1 à 10, dans laquelle une impression conductrice ne se trouve pas au niveau d'une région (324) correspondant à l'antenne à diagramme (27) sur la deuxième surface (31b).

12. Carte de circuit imprimé (30) selon l'une des revendications 1 à 11, comportant en outre au moins un trou traversant (323) formé autour du diagramme de remplissage-découpe (322) pour l'adaptation d'impédance.

13. Carte de circuit imprimé (30) selon l'une des revendications 1 à 12, dans laquelle la carte de circuit imprimé (30) comporte une carte de circuit imprimé souple.

14. Système de gestion de batterie (20), comportant la carte de circuit imprimé (30) selon l'une des revendications 1 à 13.

15. Bloc-batterie (1), comportant :
un module de batterie (10) ; et
le système de gestion de batterie (20) selon la revendication 14.
